# FASCICULE DE BREVET EUROPEEN

(11) **EP 0 366 537 B1**
(45) Date de publication et mention de la délivrance du brevet: **23.06.1993**
(21) Numéro de dépôt: 89402924.8
(22) Date de dépôt: 24.10.1989
(51) Int. Cl.: H05K 9/00

(54) **Procédé de réalisation d'un blindage, blindage obtenu par ce procédé, et matériel électronique comportant ce blindage**
Verfahren zur Herstellung einer Abschirmung, durch dieses Verfahren erhaltene Abschirmung und elektronische Anlage mit dieser Abschirmung
Process for making a screening, screening obtained by this process and an electronic equipment comprising this screening

(30) Priorité: 28.10.1988 FR 8814138
(43) Date de publication de la demande: 02.05.1990
(73) Titulaire: THOMSON-CSF, 75008 Paris (FR)
(72) Inventeur: Julien, Jean, F-92402 Courbevoie Cédex (FR)
(74) Mandataire: Courtellemont, Alain

(56) Documents cités:
- EP-A- 0 178 038
- GB-A- 2 064 629
- PATENT ABSTRACTS OF JAPAN vol. 12, no. 110 (C-486)(2957) 08 avril 1988, & JP-A-62 235480 (HITACHI CABLE) 15 octobre 1987.
- ELECTRONIC PACKAGING AND PRODUCTION. vol. 28, no. 6, juin 1988, NEWTON, MASSACHUSETT pages 33 - 35; SPITZ: "Preserving the spectrum through EMI/RFI control."

## Description

La présente invention se rapporte aux blindages utilisés pour la protection électromagnétique des matériels électroniques comportant des parois extérieures équipées de moyens d'affichage d'informations, tels que, par exemple, des boîtiers en matière composite présentant, sur une de leurs faces, des écrans ou tels que des claviers plats en polycarbonate. La présente invention concerne tout particulièrement un procédé de réalisation de ces blindages, les blindages obtenus par ce procédé et les matériels équipés des blindages ainsi obtenus.

Il existe des blindages constitués d'une toile grillagée obtenue par un entrelacement régulier de fils conducteurs. De tels blindages, à moins d'être à grandes mailles, auquel cas ils n'offrent pas une protection électromagnétique efficace, ne sont pas très perméables à la lecture étant donné que leur densité de fils est de l'ordre d'au moins cinquante pour-cent, c'est-à-dire qu'en projection dans le plan de la feuille, les trous représentent au plus cinquante pour-cent de la surface de la feuille ; la lecture des moyens d'affichage, surtout quand ils sont à cristaux liquides, pose des problèmes. De plus ces toiles grillagées ont tendance à s'effilocher sur leurs bords, en particulier au moment de leur découpe à la dimension désirée. Quant au collage de ces toiles grillagées sur les surfaces entourant les zones d'affichage, les fils ronds et entrelacés de la toile le rendent délicat à exécuter de façon satisfaisante.

Il existe également des blindages faits de grillages obtenus par sérigraphie et constitués d'un support transparent sur lequel une encre conductrice forme le grillage proprement dit. Là aussi la perméabilité à la lecture est faible et si les problèmes d'effilochage ne se posent pas avec les encres de sérigraphie, par contre ces encres sont fragiles et coûteuses.

La présente invention a pour but d'éviter ou, pour le moins, de réduire les inconvénients susmentionnés.

Ceci est obtenu, en particulier, en utilisant comme blindage une feuille conductrice préalablement découpée en grillage aux endroits où elle recouvre les zones comportant des moyens d'affichage d'informations.

Selon l'invention un procédé de réalisation d'un blindage destiné à recouvrir des surfaces comportant des zones d'affichage d'informations, est caractérisé en ce qu'il consiste à utiliser, pour ce blindage, une feuille métallique et à effectuer une découpe en grillage, par gravure chimique, aux endroits où cette feuille recouvrira les zones.

La présente invention sera mieux comprise et d'autres caractéristiques apparaîtront à l'aide de la description ci-après et des figures s'y rapportant qui représentent :
- la figure 1 une vue en coupe d'un panneau équipé d'un blindage selon l'invention,
- la figure 2, une vue de dessus du blindage utilisé dans le panneau de la figure 1,
- la figure 3, une vue de détail, agrandie d'une partie du blindage selon la figure 2,
- la figure 4, une vue de dessus d'un autre blindage selon l'invention.

Sur les différentes figures les éléments correspondants sont désignés par les mêmes repères.

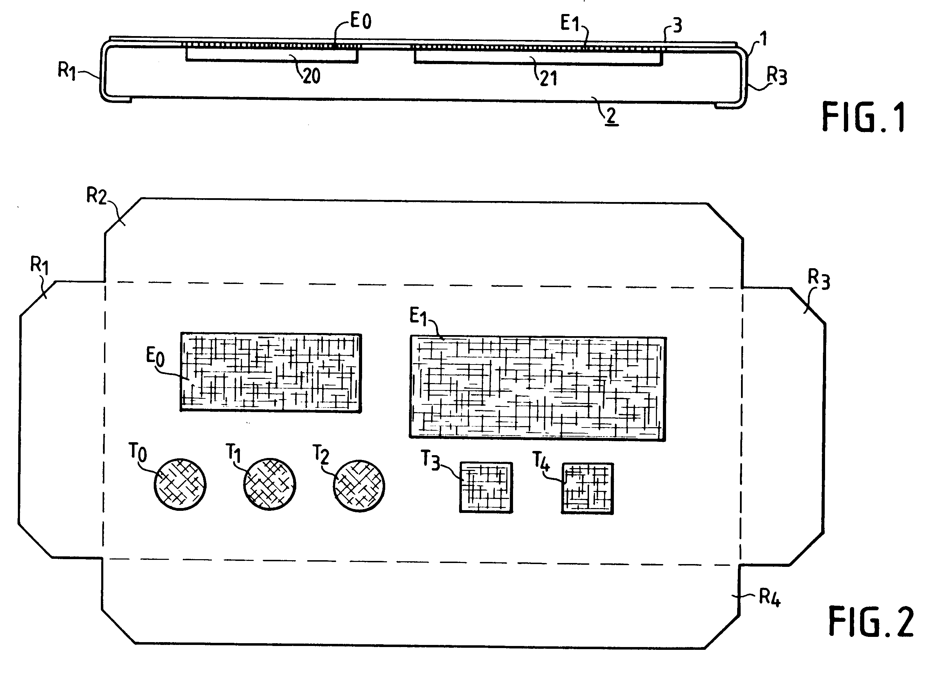

La figure 1 est une vue schématique en coupe d'un panneau de contrôle conçu pour être monté sur la face avant d'un matériel électronique. Ce panneau de contrôle comporte de l'avant vers l'arrière : une feuille plastique de protection 3 avec des inscriptions (marque de fabrique, indications techniques, décoration), un blindage 1 et un circuit imprimé multicouche 2 avec deux écrans à cristaux liquides 20, 21 visibles dans le plan de coupe. La blindage 1 est constitué par une feuille métallique conductrice d'une épaisseur de 0,05 mm, en cupronickel de la marque déposée ARCAP, localement découpée pour former des grillages tels que les grillages E0, E1 qui apparaissent dans le plan de coupe de la figure 1 ; les grillages E0, E1 recouvrent respectivement les écrans à cristaux liquides 20 et 21. La feuille du blindage 1 recouvre la face avant du circuit imprimé 2 et recouvre aussi, par des rabats tels que R1, R3, les bords du circuit imprimé et le pourtour de la face arrière du circuit imprimé. Le panneau comporte également cinq touches dites sensitives et un cordon de raccordement qui n'apparaissent pas dans le plan de coupe selon la figure 1.

La figure 2 montre comment est réalisée la feuille métallique destinée à constituer le blindage 1 selon la figure 1. Sur cette figure un rectangle a été dessiné en traits interrompus pour symboliser l'emplacement que le circuit imprimé 2 occupera derrière la feuille de blindage pour réaliser le montage selon la figure 1. Autour de ce rectangle apparaissent, sur chacun des côtés, les rabats R1 à R4. L'intérieur du rectangle présente sept zones grillagées E0, E1 et T0-T4 destinées à recouvrir respectivement les deux écrans à cristaux liquides et les cinq touches sensitives du circuit imprimé.

La où ils recouvrent les écrans, les grillages ont simplement pour rôle de permettre la lecture des cristaux liquides. Là où ils recouvrent des touches sensitives les grillages permettent la lecture des indications portées sur ces touches ; mais, même si ces indications avaient été portées sur la feuille plastique de protection, 3, de la figure 1, les grillages resteraient utiles dans la mesure où ils améliorent la souplesse de la feuille métallique au dessus des touches facilitant ainsi l'utilisation de ces touches.

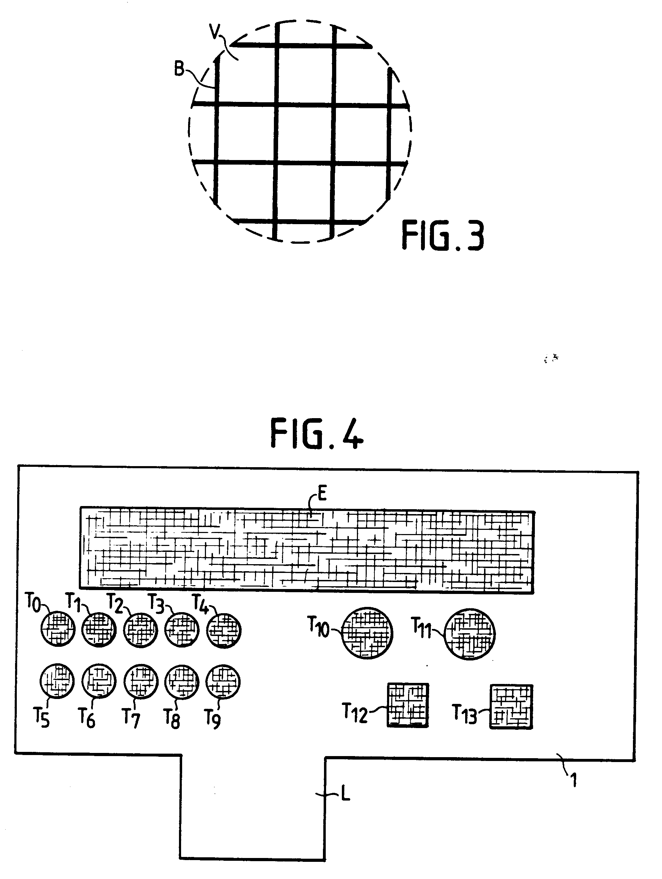

La figure 3 est une vue de détail très grossie d'un morceau des grillages du blindage selon la figure 2. Les mailles du grillage sont des mailles carrées au pas de 1 mm, formées par des bandes, B, d'un dixième de millimètre de largeur séparant des trous carrés, V, de 0,9 millimètres de côté ; avec un tel grillage les trous représentent de l'ordre de quatre-vingt pour-cent de la surface, permettant ainsi une très bonne vision des cristaux liquides et des inscriptions sur les touches.

Les grillages selon la figure 2 sont obtenus par une gravure chimique de précision. Le procédé, bien connu dans d'autres techniques, consiste, dans le cas présent, à recouvrir la feuille métallique à découper d'un film photosensible qui est mis en contact avec un calque sur lequel est dessiné à l'échelle 1 le grillage à obtenir ; il est à noter que, dans l'exemple décrit, afin d'obtenir une très bonne précision, le dessin a été effectué à l'aide d'un cordinatographe (marque déposée). Après insolation et développement la feuille recouverte de son film sensibilisé est plongée dans un bain de gravure qui attaque le métal partout où il n'est pas protégé par le film c'est-à-dire entre les bandes de la photographie du grillage telle qu'elle apparaît lors du développement.

La figure 4 est une vue de dessus d'une autre feuille métallique, 1, conçue pour former le blindage de la face avant d'un clavier équipé d'un écran à cristaux liquides et de quatorze touches sensitives. La feuille a la forme d'un rectangle prolongé, sur l'un de ses grands côtés par une languette, L. Dans cette réalisation il n'y a pas de rabats, comme dans le cas du blindage selon la figure 2, et la mise à la masse du blindage est obtenue par fixation de la languette sur le châssis de l'armoire électronique à laquelle le clavier est destiné. Le blindage selon la figure 4 comporte un grand grillage rectangulaire E conçu pour recouvrir l'écran du clavier et quatorze grillages de plus petites dimensions, T0 à T13, conçus pour recouvrir respectivement les quatorze touches du clavier ; ces grillages ont été, eux aussi, obtenus par le procédé de gravure chimique de précision décrit plus avant.

La présente invention n'est pas limitée aux exemples décrits, c'est ainsi, par exemple, que la feuille métallique du blindage peut être préformée pour épouser exactement la forme d'une surface qui ne serait pas plate. De même la découpe des zones grillagées peut être réalisée de manière que les trous soient des ronds, des rectangles, des losanges, des triangles isocèles, ou même aient toute autre forme, étant entendu que les trous carrés ont, pour une même solidité des bandes séparant les trous, l'avantage d'offrir un maximum de passage à la lumière.

## Revendications

1. Procédé de réalisation d'un blindage destiné à recouvrir des surfaces comportant des zones d'affichage d'informations, caractérisé en ce qu'il consiste à utiliser, pour ce blindage, une feuille métallique (1) et à effectuer une découpe en grillage, par gravure chimique, aux endroits (E0, E1, T0-T4 ; E, T0-T13) où cette feuille recouvrira les zones.

2. Procédé selon la revendication 1, caractérisé en ce qu'il consiste à choisir pour la feuille (1) une épaisseur inférieure à 0,1 mm et, pour la découpe en grillage, des trous (V) sensiblement carrés, de l'ordre du millimètre carré, séparés par des bandes (B) de l'ordre du dixième de millimètre.

3. Blindage recouvrant une surface comportant des zones d'affichage d'informations (20, 21), caractérisé en ce qu'il est réalisé selon le procédé décrit dans l'une quelconque des revendications précédentes et en ce qu'il est collé sur des zones de la surface comprises autour des zones d'affichage (20, 21).

4. Blindage selon la revendication 3, recouvrant la face avant d'un panneau (2), caractérisé en ce que la feuille (1) est pliée (R1-R4) autour des bords du panneau pour recouvrir, au moins au voisinage des bords la face arrière du panneau et est collée sur la face arrière.

5. Matériel électronique présentant une paroi (2) avec une surface qui comporte des zones d'affichage d'informations (20, 21), caractérisé en ce qu'il comporte un blindage selon la revendication 3, qui recouvre sa surface comportant des zones d'affichage d'informations.

## Patentansprüche

1. Verfahren zum Herstellen einer Abschirmung zum Bedecken von Flächen, die Informationsanzeigezonen aufweisen, dadurch gekennzeichnet, daß es darin besteht, für diese Abschirmung eine Metallfolie (1) zu verwenden und durch chemisches Ätzen an Stellen (E0, E1, T0 bis T4; E, T0 bis T13), an denen die Folie diese Zonen überdeckt, ein gitterartiges Einschneiden durchzuführen.

2. Verfahren nach Anspruch 1, dadurch gekennzeichnet, daß es darin besteht, für die Folie (1) eine Dicke unter 0,1 mm zu wählen und für das gitterartige Schneiden im wesentlichen quadratische Löcher (V) in der Größenordnung von Quadratmillimeter zu wählen, die durch Streifen (B) in der Größenordnung von zehn Millimeter getrennt sind.

3. Eine Fläche mit Informationsanzeigezonen (20, 21) bedeckende Abschirmung, dadurch gekennzeichnet, daß sie gemäß dem in einem der vorherigen Ansprüche beschriebenen Verfahren hergestellt ist und daß sie auf Zonen der Fläche geklebt ist, die um die Anzeigezonen (20, 21) liegen.

4. Abschirmung nach Anspruch 3, die die Frontfläche einer Tafel (2) bedeckt, dadurch gekennzeichnet, daß die Folie (1) um die Ränder der Platte gefaltet ist (R1 bis R4), um zumindest nahe den Rändern die Hinterfläche der Platte zu überdecken, und auf der Hinterfläche verklebt ist.

5. Elektronische Vorrichtung mit einer Wand (2) mit einer Fläche, die Informationsanzeigezonen (20, 21) aufweist, dadurch gekennzeichnet, daß es eine Abschirmung nach Anspruch 3 aufweist, die seine Informationsanzeigezonen enthaltende Fläche bedeckt.

## Claims

1. Method for producing a screen intended for covering surfaces comprising zones for displaying information, characterised in that it consists in using, for this screen, a metal sheet (1) and in carrying out a mesh-like cutting, by chemical etching, at the places (E0, E1, T0-T4 ; E, T0-T13) where this sheet will cover the zones.

2. Method according to Claim 1, characterised in that it consists in choosing for the sheet (1) a thickness less than 0.1 mm and, for the mesh-like cutting, substantially square holes (V), of the order of one square millimetre, separated by strips (B) of the order of one tenth of a millimetre.

3. Screen covering a surface comprising zones for displaying information (20, 21), characterised in that it is produced according to the method described in any one of the preceding claims and in that it is adhesively bonded onto zones of the surface which are situated around the display zones (20, 21).

4. Screen according to Claim 3, covering the front face of a panel (2), characterised in that the sheet (1) is folded (R1-R4) around the edges of the panel in order to cover, at least near the edges, the rear face of the panel and is adhesively bonded onto the rear face.

5. Electronic equipment having a side (2) with a surface which comprises zones for displaying information (20, 21), characterised in that it comprises a screen according to Claim 3, which covers its surface comprising zones for displaying information.
